# DEMANDE DE BREVET EUROPEEN

(11) **EP 0 822 569 A1**
(43) Date de publication de la demande: **04.02.1998**
(21) Numéro de dépôt: 97401797.2
(22) Date de dépôt: 25.07.1997
(51) Int. Cl.: H01J 9/02, G03F 7/20

(54) **Procédé et dispositif de formation de motifs dans une couche de résine photosensible par insolation laser continue, application à la fabrication de sources d'électrons à cathodes émissives à micropointes et d'écrans plats de visualisation**

(30) Priorité: 29.07.1996 FR 9609520
(71) Demandeur: COMMISSARIAT A L'ENERGIE ATOMIQUE, 75015 Paris Cédex 15 (FR)
(72) Inventeur: Ida, Michel, 38340 Voreppe (FR); Rabarot, Marc, 38170 Seyssinet (FR)
(74) Mandataire: Dubois-Chabert, Guy

(57) **Abrégé**

Procédé et dispositif de formation de motifs dans une couche de résine photosensible par insolation laser continue, application à la fabrication de sources d'électrons à cathodes émissives à micropointes et d'écrans plats de visualisation.

Selon l'invention, on forme des faisceaux lumineux focalisés (41), on effectue au moins une translation relative, à vitesse et puissance lumineuse constantes, de ces faisceaux par rapport à la couche (22) pour insoler des lignes de cette couche, chaque ligne recevant une dose de lumière inférieure à celle qui est nécessaire au développement de la résine, on effectue une rotation relative de l'ensemble des faisceaux par rapport à la couche, on recommence la translation pour insoler d'autres lignes, chaque autre ligne recevant une dose de lumière complémentaire de la précédente et on développe la résine.

## Description

### DOMAINE TECHNIQUE

La présente invention concerne un procédé de formation de motifs, tels que des trous par exemple, dans une couche de résine photosensible ("photoresist") ainsi qu'un dispositif permettant la mise en oeuvre de ce procédé.

L'invention s'applique notamment à la fabrication de sources d'électrons à cathodes émissives à micropointes ("microtips") qui sont utilisées en particulier pour la fabrication de dispositifs de visualisation par cathodoluminescence excitée par émission de champ.

L'invention permet par exemple de fabriquer des écrans plats à micropointes de grande taille, par exemple supérieure à 14 pouces (environ 35 cm), et même des écrans plats à micropointes dont la superficie est voisine de 1 m².

Bien entendu des écrans de taille nettement plus grande peuvent être élaborés grâce à la présente invention.

### ÉTAT DE LA TECHNIQUE ANTÉRIEURE

Des sources d'électrons à cathodes émissives à micropointes et leurs procédés de fabrication sont décrits par exemple dans les documents (1) à (4) auxquels on se reportera et qui, comme les autres documents cités par la suite, sont mentionnés à la fin de la présente description.

Pour faciliter la compréhension du problème technique résolu par la présente invention, on décrit ci-après un exemple connu de procédé de fabrication d'une source d'électrons à cathodes émissives à micropointes.

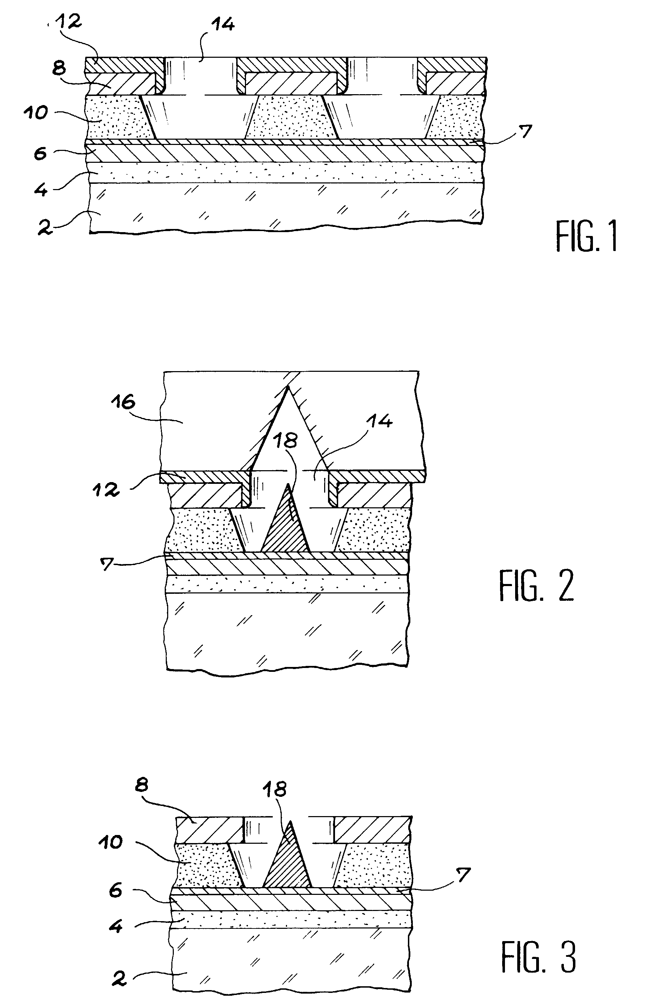

On se référera aux figures 1 à 3 des dessins annexés.

La figure 1 montre une structure déjà élaborée, comprenant, sur un substrat 2 surmonté d'un isolant 4, un système composé de conducteurs cathodiques 6, d'une couche résistive 7 et de grilles 8, les conducteurs 6 et les grilles 8 étant superposés sous forme croisée, avec un isolant intermédiaire 10, et une couche 12, par exemple en nickel, déposée en surface pour servir de masque lors des opérations de réalisation des micropointes.

Cette couche 12 de nickel, les grilles 8 et l'isolant 10 sont percés de trous 14, au fond desquels il s'agit de déposer ultérieurement les micropointes constituées d'un métal conducteur en liaison électrique avec les conducteurs cathodiques 6 à travers la couche résistive 7.

La réalisation des micropointes va maintenant être expliquée en faisant référence à la figure 2.

On commence d'abord par effectuer par exemple le dépôt d'une couche en molybdène 16 sur l'ensemble de la structure.

Cette couche 16 présente une épaisseur d'environ 1,8 µm.

Elle est déposée sous incidence normale par rapport à la surface de la structure.

Cette technique de dépôt permet d'obtenir des cônes 18 en molybdène logés dans les trous 14 et ayant une hauteur de 1,2 à 1,5 µm.

Ces cônes constituent les micropointes émettrices d'électrons.

On réalise ensuite la dissolution sélective de la couche de nickel 12 par un procédé électrochimique, de façon à dégager, comme on le voit sur la figure 3, les grilles perforées 8, par exemple en niobium, et à faire apparaître les micropointes 18 émettrices d'électrons.

A quelques variantes technologiques près, la méthode connue ainsi décrite en se référant aux figures 1, 2 et 3 est l'une de celles qui sont utilisées pour réaliser les micropointes des sources d'électrons à cathodes émissives à micropointes.

Pour que la taille et le positionnement des micropointes 18 soient corrects il faut, bien entendu, maîtriser parfaitement la taille des trous réalisés dans les grilles 8 et dans l'isolant 10.

Le problème est le suivant :

Il s'agit de réaliser, sur toutes les surfaces devant recevoir des micropointes, des trous dont le diamètre moyen est par exemple de 1,3 µm ou moins.

Les méthodes actuellement utilisées pour réaliser ces trous font appel à des procédés de photolithogravure utilisant la projection directe ou la photorépétition d'un motif élémentaire reproduit sur toutes ces surfaces.

Dans le cas de sources d'électrons de grande taille, supérieure à 14 pouces (environ 35 cm) par exemple, ces procédés deviennent vite très contraignants.

La projection directe nécessite la réalisation d'un masque à l'échelle 1 de grande taille, comportant des motifs submicroniques.

Ces motifs sont en général composés de métal en couche mince déposé sur un substrat de silice ou de verre.

Ce masque est difficilement réalisable au dessus de 14 pouces de diagonale avec les techniques classiques utilisées en micro-électronique.

En ce qui concerne la photorépétition, on utilise un masque de petite taille, cette taille étant déterminée par la résolution des motifs utilisés.

Pour une résolution de 1 µm, on utilise par exemple un masque de 20 à 50 mm de côté, ce qui oblige à répéter un grand nombre de fois l'opération d'insolation qui est nécessaire à la photolithogravure, pour couvrir la surface totale de la source d'électrons.

Ces deux méthodes (l'une utilisant la projection directe et l'autre la photorépétition) sont donc difficilement applicables à la réalisation de sources d'électrons de grande taille.

Une autre méthode citée dans la littérature (voir les documents (5), (6), (7) et (8)) consiste à réaliser une photolithographie à l'aide d'interférences laser, pour insoler une résine photosensible.

Cette technique consiste à créer un réseau de franges lumineuses à la surface de la résine en faisant interférer deux faisceaux laser faisant un angle déterminé, issus d'un même laser, et ensuite à recommencer cette opération après avoir tourné le substrat de 90°.

On obtient ainsi une zone insolée en forme de grille dont les intersections sont deux fois plus insolées que le reste.

Après développement de la résine et dans le cas où l'on utilise une résine positive, on obtient donc une matrice de trous dont la période (distance entre deux trous) est égale à la distance entre deux franges lumineuses.

Parmi les publications récentes qui citent ce procédé, on retiendra celle de J.P. SPALLAS et al., *Lawrence Livermore National Laboratory* (IVMC95) qui mentionne la réalisation d'une matrice de 10¹¹ pointes, de diamètre 330 nm, sur un substrat de 50 cm² (voir le document (5)).

Néanmoins, les auteurs de cette publication restent très discrets sur les résultats obtenus.

En fait, les photos AFM publiées (AFM signifiant microscope à force atomique) sont dans tous les cas réalisées sur de petits substrats de quelques cm².

On notera par exemple la réalisation d'une matrice de pointes en résine photosensible, de 330 nm de diamètre, espacées de 670 nm et ayant une hauteur de 250 nm, sur un substrat de 2,5 cm x 7,5 cm.

En ce qui concerne leurs essais sur une plaque de 50 cm², les conditions expérimentales sont les suivantes :
- laser krypton émettant un rayonnement de longueur d'onde 413 nm
- résine commercialisée par la Société Shipley sous la référence 1400, dont l'indice de réfraction est voisin de celui du substrat de verre, pour éviter les interférences
- étalement de la résine réalisé dans un système appelé *"meniscus coating"*
- temps total d'insolation de 4 minutes (2 minutes pour chaque demi-insolation).

En fait, aucune information n'est donnée sur les défauts d'uniformité qui doivent probablement apparaître du fait des imperfections du profil des faisceaux lasers.

Rien n'est dit non plus sur la collimation de ces faisceaux laser.

D'autre part, cette technique restreint considérablement le choix de la configuration et de la répartition des trous.

En effet, la période P de la matrice, c'est-à-dire la distance entre deux trous successifs, est directement liée à la longueur d'onde *λ* du laser utilisé et à l'angle θ entre les deux faisceaux issus de ce laser, faisceaux que l'on fait interférer pour créer le réseau de franges lumineuses.

On peut écrire : P = λ/(2sinθ).

En conséquence, pour une longueur d'onde λ du laser et un angle θ donnés, on ne pourra faire qu'une matrice de trous dont l'écartement est fixe.

La taille des trous est déterminée par la largeur des franges d'interférences.

La présente invention évite tous les problèmes précités.

Elle permet de réaliser un masque pour la formation des trous correspondant aux émetteurs d'électrons, de façon beaucoup plus simple que les techniques connues, mentionnées ci-dessus.

Elle concerne un procédé très simple de formation de trous ou d'autres motifs dans une couche de résine photosensible, ainsi qu'un dispositif pour la mise en oeuvre de ce procédé.

L'invention permet de former des trous dont le diamètre peut être de l'ordre de 1 µm ou inférieur à 1 µm, sur de petites surfaces ou sur de grandes surfaces.

L'invention permet d'insoler une couche de résine photosensible à l'aide d'un faisceau laser sans réaliser des interférences lumineuses.

Cette résine photosensible, une fois développée (c'est-à-dire après dissolution des zones insolées), peut servir de masque pour former des motifs, comme par exemple des trous pour sources d'électrons à micropointes, dans une structure sur laquelle se trouve la couche de résine photosensible.

Par exemple, en considérant la structure décrite en faisant référence aux figures 1 à 3, la couche de résine photosensible peut servir, après développement, à graver les grilles 8 et l'isolant intermédiaire 10.

Un but de la présente invention est de proposer un procédé et un dispositif de réalisation de motifs micrométriques ou submicrométriques, en creux ou en relief, dans une couche de résine photosensible.

La présente invention vise aussi un procédé de formation de motifs en creux, par exemple des trous, ou en relief, par photolithographie laser d'une couche de résine photosensible et gravure d'une ou d'une pluralité de couches placées sous cette résine photosensible.

Un autre but de l'invention est de proposer un procédé qui soit simple à mettre en oeuvre et qui permette de traiter des substrats présentant une couche de résine photosensible de grande surface par exemple 1 m².

### EXPOSÉ DE L'INVENTION

Les auteurs de la présente invention ont cherché à évaluer les possibilités de photolithographie des trous par écriture laser directe dans l'état actuel des connaissances en matière de laser (sans réaliser d'interférence lumineuses).

Les problèmes techniques qui se posent sont exposés ci-après.

L'hypothèse de départ est toujours la même : on cherche à réaliser par exemple 10⁴ trous par mm² sur un substrat de taille voisine de 1 m².

Les paramètres initiaux sont donc les suivants :
- 10¹⁰ trous à réaliser
- diamètre des trous : 1 µm
- surface d'un trou : 0,785 µm²
- photosensibilité de la résine photosensible : S=300 mJ/cm² (valeur classique).

On en déduit la dose de lumière D qui est nécessaire à l'insolation d'un trou : D=2,4 nW/s.

Considérons les limitations des systèmes lasers existants, à savoir les diodes lasers, les microlasers, les lasers à gaz et les lasers solides de type YAG.

Les diodes lasers fonctionnent à des fréquences de l'ordre de 1 MHz.

Elle délivrent une puissance-crête de quelques watts qui pourrait satisfaire à l'application considérée ici mais il est impossible dans l'état de l'art actuel de focaliser le faisceau laser sur des surfaces aussi petites.

Quant aux microlasers, les fréquences de fonctionnement actuellement utilisables sont de l'ordre de 10 kHz et il n'existe pas de microlaser capable d'émettre dans le domaine ultraviolet.

Les microlasers ne sont donc pas utilisables pour l'application considérée ici.

En ce qui concerne les lasers à gaz, dans le domaine ultraviolet, les lasers excimères existants fonctionnent à quelques W/cm² en mode continu mais, en mode pulsé, les fréquences maximales sont de l'ordre de quelques dizaines de hertz.

Ces lasers à gaz ne satisfont donc pas à l'application considérée ici.

Quant aux lasers solides de type YAG, en triplant la fréquence de ces lasers, on peut travailler aux environs de 355 nm.

En mode continu, on obtient sans problème quelques watts.

Par contre, ces lasers solides sont inutilisables pour l'application considérée ici, en mode pulsé, car la fréquence maximale est d'environ 10 kHz.

On pourrait envisager une écriture par insolation séquentielle trou par trou.

On cherche dans ce cas à insoler les trous et rien d'autre.

Une solution consiste par exemple à utiliser un laser YAG et à s'afffranchir du problème de fréquence en divisant le faisceau lumineux produit en de multiples faisceaux élémentaires (1000 par exemple).

On utilise pour ce faire une nappe de fibres optiques ou un réseau multiplicateur d'image couplé à une barrette de microlentilles pour refocaliser les faisceaux élémentaires en sortie.

Ces microlentilles existent en barrette intégrée et on peut disposer d'une microlentille tous les 100 µm environ, ce qui conduit à un dispositif de 10 cm de long.

Ensuite, le problème à résoudre est de coordonner le déplacement et l'alignement du système obtenu avec la modulation du faisceau laser.

Un déplacement mécanique suivant deux directions perpendiculaires X et Y est inconcevable du fait de la vitesse nécessaire.

Il serait peut-être possible de s'inspirer des systèmes à miroirs tournants utilisés dans les photocopieurs pour dévier les faisceaux élémentaires d'un laser YAG pulsé et éviter de déplacer à chaque fois la barrette.

Avec un tel système, il faudrait photorépéter une séquence de tirs laser avec arrêt du laser et alignement entre chaque séquence.

Une autre solution consisterait à travailler avec un laser YAG en mode continu et à déplacer les faisceaux élémentaires suffisamment rapidement entre les trous pour ne pas insoler la résine.

Cette solution évite de synchroniser le déplacement et l'alignement sur la fréquence de tir du laser YAG pulsé.

Un rapide calcul permet d'estimer la vitesse de déplacement nécessaire.

Supposons que l'on utilise un laser de 1 W permettant de créer 1000 faisceaux élémentaires de 1 mW.

On a besoin de 2,4 nJ par trou et il faut donc insoler chaque trou pendant 2,4x10⁻⁶ seconde.

Le temps total d'irradiation pour 1 m² est donc d'environ 25 secondes (puisqu'il y a 10¹⁰ trous), ce qui est tout à fait raisonnable.

Mais le plus gros problème reste le déplacement entre les trous.

Si l'on considère qu'il faut rester deux fois moins de temps sur la résine photosensible entre les trous pour éviter de l'insoler et que l'intervalle est d'environ 4 µm, il faut déplacer les faisceaux élémentaires ou la plaque portant la résine photosensible à une vitesse d'environ 4 m/s mais en plus il faut la déplacer à chaque fois de quelques micromètres.

Malheureusement, dans l'état actuel de la technique, les meilleurs déplacements piézo-électriques qui permettraient de déplacer la plaque de quelques micromètres ne permettent pas d'obtenir des vitesses supérieures à quelques cm/s.

Donc la limitation se trouve là : il semble bien difficile, voire impossible, de déplacer une plaque de 1 m² ou une barrette de 10 cm de quelques µm avec une course totale voisine de 1 m et à une vitesse de 4 m/s sans s'arrêter.

La présente invention évite d'avoir à résoudre ce problème.

Pour ce faire, l'invention utilise une écriture par insolation continue.

On utilise le même type de système que précédemment avec un multiplicateur d'image (x1000) et un laser YAG continu.

La technique utilisée consiste à faire simplement défiler en continu les 1000 faisceaux élémentaires à une vitesse continue sur toute la plaque à traiter de façon à obtenir une succession de lignes parallèles sur la résine photosensible.

La grande différence avec ce qui a été dit précédemment réside dans le fait qu'on ne s'arrête plus à chaque trou et qu'on n'a donc plus besoin d'un déplacement piézo-électrique.

Chaque ligne est insolée à la moitié de la dose nécessaire au développement.

Ensuite la plaque est tournée de 90° et l'on reproduit le même tracé de lignes.

La figure obtenue est une grille dont les intersections ont reçu une dose de lumière permettant le développement de trous en ces intersections.

On choisit par exemple un laser deux fois moins puissant que précédemment (1/2 W) pour insoler les lignes à la moitié de la dose nécessaire au développement et l'on fait défiler la plaque à la même vitesse de 4 m/s, ce qui est tout à fait concevable vu que l'on a un déplacement continu de la plaque.

Le temps total de traitement est de l'ordre de 1 minute ou de quelques minutes si l'on tient compte des déplacements verticaux et des dépassements en fin de plaque.

On peut choisir un laser de puissance plus faible ou bien une barrette comportant plus de mille fibres optiques.

La vitesse de défilement de la plaque devant les fibres optiques est plus lente dans ce dernier cas et l'on choisit alors un système de motorisation moins rapide.

Il faut insister sur le caractère binaire de la technique utilisée dans la présente invention : à chaque intersection on obtient un trou et il n'y en a pas ailleurs.

En effet, on ne se place pas dans le cas où l'on cherche à moduler la puissance du laser pour obtenir des motifs de résine en pente comme c'est le cas dans les documents (9) à (15).

De façon précise, la présente invention a pour objet un procédé de formation de motifs dans une couche de résine photosensible, ce procédé étant caractérisé en ce qu'il comprend les étapes suivantes :
- on forme des faisceaux lumineux élémentaires dont les axes sont parallèles,
- on effectue au moins une première translation relative, à vitesse et puissance lumineuse constantes, de ces faisceaux élémentaires par rapport à la couche de résine photosensible, les faisceaux élémentaires étant focalisés sur celle-ci, de manière à insoler des premières lignes parallèles de cette couche, ladite vitesse et ladite puissance étant choisies de façon que chaque première ligne insolée reçoive une première dose de lumière inférieure à la dose de lumière nécessaire au développement de cette résine photosensible,
- on effectue une rotation relative d'un angle déterminé, de l'ensemble des faisceaux lumineux élémentaires par rapport à la couche de résine photosensible,
- on effectue au moins une deuxième translation relative, à vitesse et puissance lumineuse constantes, de ces faisceaux élémentaires par rapport à la couche de résine photosensible, les faisceaux élémentaires étant focalisés sur celle-ci, de manière à insoler des deuxièmes lignes parallèles de cette couche, ladite vitesse et ladite puissance lumineuse étant choisies de façon que chaque deuxième ligne insolée reçoive une deuxième dose de lumière égale à la différence entre ladite dose de lumière nécessaire au développement et la première dose, de sorte que seules les intersections des premières et des deuxièmes lignes reçoivent cette dose nécessaire au développement, et
- on développe la résine photosensible, des motifs étant ainsi formés en ces intersections.

Selon un mode de mise en oeuvre préféré du procédé objet de l'invention, les première et deuxième translations relatives sont effectuées à la même vitesse et à la même puissance lumineuse, cette vitesse et cette puissance lumineuse étant choisies de façon que les première et deuxième doses de lumière soient toutes deux égales à la moitié de la dose nécessaire au développement.

De préférence, l'angle de la rotation relative est égal à 90°.

Selon un premier mode de mise en oeuvre particulier du procédé objet de l'invention, la couche de résine photosensible reste fixe et l'ensemble de faisceaux lumineux élémentaires est déplacé par rapport à cette couche lors des première et deuxième translations.

Selon un deuxième mode de mise en oeuvre particulier, l'ensemble de faisceaux lumineux élémentaires reste fixe et la couche de résine photosensible est déplacée par rapport à cet ensemble lors des première et deuxième translations.

Selon un troisième mode de mise en oeuvre particulier, l'ensemble de faisceaux lumineux élémentaires et la couche de résine photosensible sont déplacés en sens contraires lors des première et deuxième translations.

Ceci permet d'utiliser une motorisation deux fois moins rapide que dans les deux modes de mise en oeuvre précédents.

Selon un mode de mise en oeuvre particulier de l'invention, on effectue au moins une série de plusieurs premières translations successives et également au moins une série de plusieurs deuxièmes translations successives et on effectue, entre deux première translations successives et entre deux deuxièmes translations successives, une translation relative de l'ensemble de faisceaux lumineux élémentaires par rapport à la couche de résine photosensible, perpendiculairement aux lignes correspondantes et avec un pas tel que la distance entre deux faisceaux lumineux adjacents soit un multiple de ce pas.

Dans ce cas, selon un autre mode de mise en oeuvre particulier, on effectue une pluralité de séries de premières et deuxièmes translations et on effectue, entre deux séries successives, une translation relative de l'ensemble de faisceaux lumineux élémentaires par rapport à la couche de résine photosensible, perpendiculairement aux lignes correspondantes et avec un pas égal à la somme de la distance entre les axes des faisceaux lumineux élémentaires les plus éloignés l'un de l'autre et de la distance entre deux lignes correspondantes adjacentes.

On peut utiliser une résine photosensible positive, les motifs formés étant alors des trous.

Au contraire, on peut utiliser une résine photosensible négative, les motifs formés étant alors des plots.

Dans ce dernier cas, l'invention s'applique à la fabrication d'optiques diffractives binaires.

La présente invention a également pour objet un dispositif de formation de motifs dans une couche de résine photosensible, pour la mise en oeuvre du procédé objet de l'invention, ce dispositif étant caractérisé en ce qu'il comprend :
- une source lumineuse apte à émettre un faisceau lumineux dont la puissance est constante,
- des moyens de formation desdits faisceaux lumineux élémentaires focalisés, à partir du faisceau lumineux de puissance constante, et
- des moyens de translation et de rotation relatives des moyens de formation desdits faisceaux lumineux élémentaires par rapport à la couche de résine photosensible, ces moyens de translation et de rotation relatives étant prévus pour effectuer lesdites première et deuxième translations relatives et ladite rotation relative.

Selon un mode de réalisation particulier du dispositif objet de l'invention, les moyens de formation desdits faisceaux lumineux élémentaires focalisés comprennent :
- un ensemble de fibres optiques, ces fibres optiques ayant des premières extrémités, dont les axes sont parallèles les uns aux autres, et des deuxièmes extrémités qui sont optiquement couplées à la source lumineuse, de manière à former les faisceaux lumineux élémentaires respectivement dans les fibres optiques, et
- un ensemble de moyens optiques de focalisation qui sont optiquement couplés respectivement aux premières extrémités des fibres optiques et aptes à focaliser les faisceaux lumineux élémentaires sur la couche de résine photosensible.

La présente invention concerne aussi un procédé de fabrication d'une source d'électrons à cathodes émissives à micropointes, procédé selon lequel :
- on forme une structure comprenant des conducteurs cathodiques sur un substrat, une couche électriquement isolante, des grilles qui font un angle avec les conducteurs cathodiques,
- dans les domaines où les grilles croisent les conducteurs cathodiques, on forme des trous à travers les grilles et la couche isolante, et
- on forme des micropointes en matériau émetteur d'électrons dans ces trous, sur les conducteurs cathodiques,
ce procédé étant caractérisé en ce que ces trous sont obtenus en formant une couche de résine photosensible positive au moins dans lesdits domaines, à la surface de la structure, en formant des trous dans la couche de résine conformément au procédé de formation de motifs objet de l'invention, et en gravant les grilles et la couche isolante à travers ces trous formés dans la couche de résine.

L'invention concerne aussi un écran plat utilisant la source ainsi fabriquée.

### BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :
- les figures 1 à 3, déjà décrites, illustrent de façon schématique et partielle un procédé connu de fabrication d'une source d'électrons à cathodes émissives à micropointes,
- la figure 4 est une vue schématique et partielle d'un dispositif permettant la mise en oeuvre d'un procédé conforme à l'invention,
- la figure 5 est une vue schématique d'une partie de ce dispositif, et
- la figure 6 illustre schématiquement ce procédé conforme à l'invention.

### EXPOSÉ DÉTAILLÉ DE MODES DE RÉALISATION PARTICULIERS

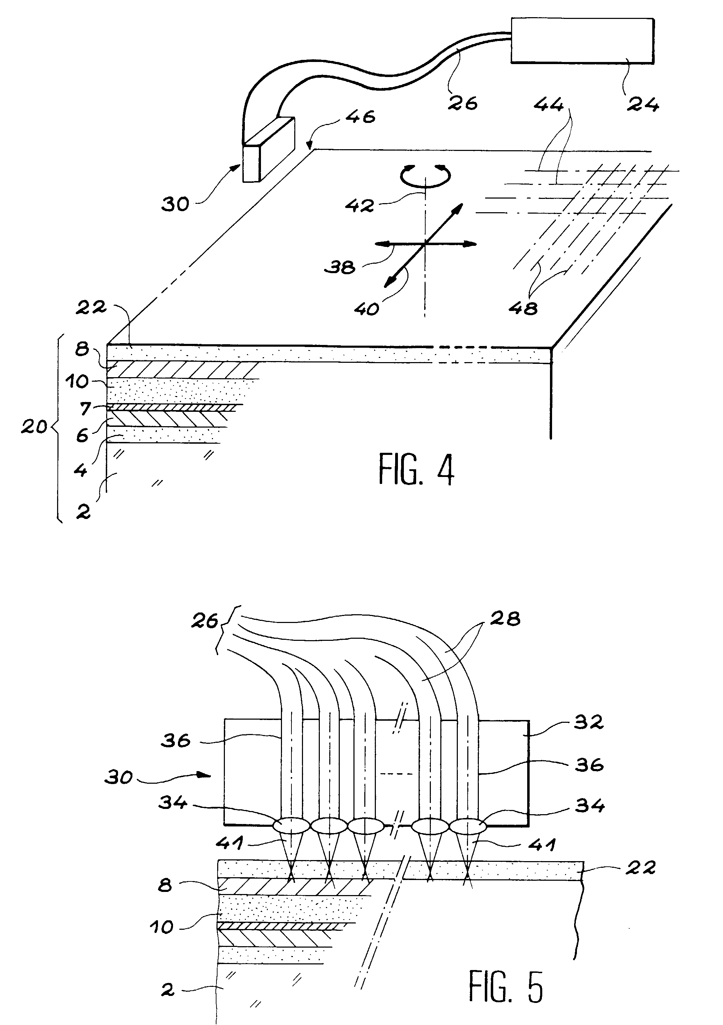

La figure 4 montre de façon schématique et partielle la structure dont il a été question dans la description des figures 1 à 3 et qui comprend le substrat 2, l'isolant 4, les conducteurs cathodiques 6, la couche résistive 7, les grilles 8 et l'isolant intermédiaire 10.

On se propose de faire des trous dans les grilles 8 et l'isolant intermédiaire 10 grâce à un procédé conforme à la présente invention.

Pour faire ces trous, on dépose sur la surface de la structure, qui porte la référence 20 sur la figure 4, une couche 22 de résine photosensible positive.

Le dispositif, qui est schématiquement représenté sur la figure 4 et dont une partie est représentée de façon plus détaillée sur la figure 5, permet la mise en oeuvre de ce procédé conforme à l'invention.

Ce dispositif comprend :
- un laser 24 de type YAG qui fournit un faisceau lumineux,
- une nappe 26 de fibres optiques 28, et
- des moyens 30 de focalisation de faisceaux lumineux.

Ces moyens de focalisation 30 comprennent une barrette 32 munie de microlentilles 34 respectivement associées aux fibres optiques 28.

Une extrémité de chaque fibre optique 28 est optiquement couplée, par des moyens non représentés, au laser 24.

Ainsi, le faisceau lumineux émis par ce laser se divise en autant de faisceaux élémentaires qu'il y a de fibres optiques, chaque fibre étant parcourue par l'un des faisceaux lumineux élémentaires.

L'autre extrémité 36 de chaque fibre optique 28 est rendue rigidement solidaire de la barrette 32 et optiquement couplée à la microlentille 34 qui lui est associée, comme on le voit sur la figure 5.

Les axes optiques des extrémités 36 des fibres optiques 28 sont respectivement confondus avec les axes optiques des microlentilles 34.

Celles-ci ont pour fonction de focaliser les faisceaux lumineux élémentaires transportés par les fibres optiques 28 sur la couche de résine photosensible 22.

A titre purement indicatif et nullement limitatif, la barrette 32 comprend un millier de fibres optiques 28 qui sont optiquement couplées à un millier de microlentilles 34 de 10 µm de diamètre.

Le dispositif des figures 4 et 5 comprend également des moyens de déplacement en translation de la barrette 32 suivant deux directions perpendiculaires l'une à l'autre, au-dessus de la couche de résine photosensible 22.

Ces moyens de déplacement en translation sont symboliquement représentés sur la figure 4 par des flèches 38 et 40 qui sont perpendiculaires l'une à l'autre.

La barrette 32 et donc les faisceaux lumineux élémentaires focalisés 41 issus des microlentilles 34 sont ainsi capables de se déplacer au-dessus de la totalité de la couche de résine photosensible 22.

Dans un autre mode de réalisation non représenté, la barrette 32 reste fixe et c'est au contraire la couche de résine photosensible 22 qui est déplaçable par rapport à cette barrette, suivant les deux directions perpendiculaires l'une à l'autre.

Plus précisément, dans ce cas, la structure 20 munie de la couche de résine photosensible 22 est placée sur un support (non représenté) et ce support est muni de moyens de déplacement en translation suivant ces deux directions perpendiculaires l'une à l'autre, par rapport à la barrette 32 qui reste fixe.

Dans un autre mode de réalisation non représenté, la barrette 32 et ce support sont tous deux déplaçables suivant ces deux directions perpendiculaires l'une à l'autre, dans des sens inverses l'un de l'autre, ce qui permet, comme on l'a vu plus haut, d'utiliser une motorisation deux fois moins rapide.

Le dispositif des figures 4 et 5 comprend aussi des moyens de rotation de la barrette 32 et donc des faisceaux lumineux élémentaires focalisés par les microlentilles 34, autour d'un axe 42 qui est perpendiculaire à la couche de résine photosensible 22 et donc aux directions 38 et 40 (qui sont parallèles à cette couche de résine photosensible 22).

Dans l'exemple représenté, l'angle de rotation est égal à 90°.

Dans un autre mode de réalisation particulier non représenté, c'est au contraire le support de la structure 20 (et de la couche de résine photosensible 22) qui est muni de moyens permettant de le faire tourner de 90° autour de cet axe 42 (la barrette 32 n'étant alors pas déplaçable en rotation).

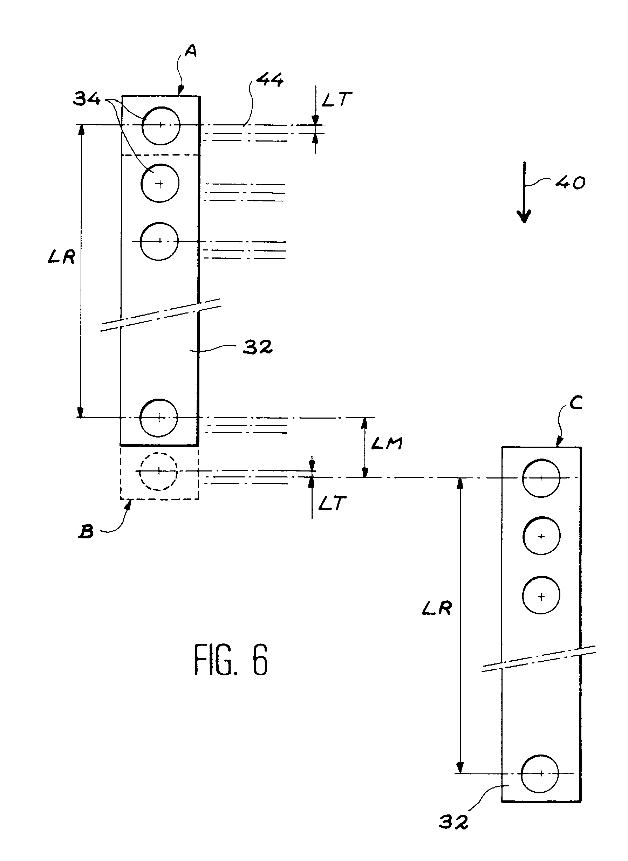

En revenant au dispositif décrit en faisant référence aux figures 4 et 5, on voit sur la figure 6 une représentation en gros plan de la barrette 32 vue de dessus.

Les microlentilles 34 ne sont pas toutes représentées sur la figure 6 et, dans un souci de simplification, les échelles n'ont pas été respectées.

Comme on le verra plus en détail par la suite, le dispositif des figures 4, 5 et 6 permet d'insoler la couche de résine 22 suivant des lignes droites parallèles 44.

La figure 6 n'a d'intérêt que pour faciliter la compréhension du déplacement de la barrette 32 suivant la direction 40.

Le déplacement de la barrette 32 selon la direction 38 n'est pas représenté sur la figure 6.

On explique ci-après comment former les trous 14 dans les grilles et l'isolant intermédiaire dont il a été question dans la description des figures 1 à 3, en utilisant un procédé conforme à la présente invention.

Plus précisément, on souhaite former une source à cathodes émissives à micropointes et, pour ce faire, on commence par former sur le substrat 2, l'isolant 4, les conducteurs cathodiques 6, la couche résistive 7, l'isolant intermédiaire 10 et les grilles 8 dont il a été question plus haut.

Dans le cas où cela est nécessaire, on masque ensuite, en une ou plusieurs étapes, les zones où l'on ne veut pas réaliser de trous.

Pour ceci, on se reportera par exemple au document (2) mentionné plus haut.

Ensuite, conformément à la présente invention, on étale la couche de résine photosensible 22 sur toute la surface de la structure 20 obtenue.

L'épaisseur de cette couche de résine photosensible 22 vaut par exemple 1 µm.

On durcit ensuite cette couche de résine photosensible par étuvage.

Puis on insole la résine photosensible de la façon suivante.

La barrette 32 est déplacée parallèlement au plan de la couche de résine photosensible 22, en partant par exemple du coin supérieur gauche (référencé 46 sur la figure 4) de cette couche de résine photosensible 22 et en balayant latéralement la couche 22 dans la direction 38, sur toute la largeur de cette couche de résine photosensible 22.

Cette opération permet d'insoler une première série de lignes 44 que l'on voit sur les figures 4 et 6.

La vitesse de défilement de la barrette 32 (ou, dans un autre mode de réalisation particulier, la vitesse de défilement du support de la structure 20 munie de la couche 22 si la barrette reste fixe) est choisie de façon à insoler la résine photosensible à la moitié de la dose nécessaire au développement de cette résine photosensible.

Ensuite, la barrette 32 est déplacée vers l'avant de la couche de résine photosensible 22 (suivant la direction 40), d'une distance égale au pas LT du réseau de lignes 44 que l'on veut insoler, ce pas étant par exemple égal à 4 µm.

On recommence l'opération précédente pour insoler une deuxième série de lignes qui sont parallèles aux lignes déjà formées.

Ce déplacement est également schématisé sur la figure 6.

Initialement, la barrette 32 est dans la position référencée A sur la figure 6.

Les deux opérations en question sont répétées autant de fois qu'il est nécessaire pour réaliser un réseau de lignes qui sont toutes espacées du même pas LT, qui est égal à 4 µm dans l'exemple considéré, sans repasser sur la même ligne.

Pour des lentilles de diamètre de 100 µm, on répète l'opération 24 fois.

Cette succession de tracés de lignes droites parallèles permet de réaliser un réseau dont la largeur LR dans la direction 40 est égale à la distance entre la première microlentille et la dernière microlentille de la barrette 32, plus la distance LM entre deux centres de microlentilles successives, moins le pas LT entre deux lignes, c'est-à-dire dans l'exemple considéré : 10 cm+100 µm-4 µm.

A la fin de cette première étape, la barrette 32 se trouve dans la position référencée B sur la figure 6.

L'étape suivante du procédé consiste à déplacer la barrette 32 dans la direction 40 d'une distance égale à LR+LT.

La barrette 32 se trouve alors dans la position référencée C sur la figure 6.

Ensuite, on recommence les deux opérations précédentes.

On procède ainsi pour recouvrir toute la surface de la couche de résine photosensible 22 d'un réseau de lignes parallèles qui sont toutes espacées de 4 µm dans l'exemple considéré.

Il est à noter qu'il est nécessaire que la distance entre deux centres de microlentilles adjacentes soit un multiple entier du pas entre les lignes.

Dans le cas contraire, le réseau de lignes ne serait pas parfaitement régulier.

L'étape suivante du procédé consiste à faire tourner de 90° la structure 20, munie de la couche de résine photosensible 22, et à recommencer toutes les opérations précédentes afin de créer un deuxième réseau de lignes droites 48 (voir la figure 4) qui sont perpendiculaires aux lignes 44 du premier réseau, en insolant encore la couche de résine photosensible 22 à la moitié de la dose nécessaire au développement de cette résine photosensible.

Ces deux réseaux forment un grillage dont les intersections ont reçu une dose de lumière qui permet le développement de la couche de résine photosensible 22.

Après développement, on obtient ainsi une matrice de trous dans la couche de résine photosensible, chaque trou étant formé en l'une des intersections.

Le diamètre de ces trous est bien évidemment fonction de la largeur des lignes.

Cette largeur est elle-même fonction des caractéristiques optiques des microlentilles 34.

Le diamètre et la forme des trous dépendent aussi du contraste de la résine photosensible utilisée.

Après développement de la couche de résine photosensible et obtention des trous dans celle-ci, cette couche de résine photosensible ainsi micro-perforée sert elle-même de masque pour la formation de trous dans les couches sous-jacentes 8 et 10 de la structure 20, pour l'obtention d'une structure conforme à la figure 1 déjà décrite.

Plus précisément, on grave à travers les trous formés dans la couche de résine photosensible, les grilles 8 et l'isolant intermédiaire 10 pour y former les trous 14 (figure 1).

On enlève ensuite la couche de résine photosensible 22.

Ensuite, on dépose sous incidence rasante la couche de nickel 12 sur la structure obtenue.

On dépose ensuite la couche de molybdène 16, d'où la formation des micropointes 18, et l'on enlève la couche de nickel 12 et la couche de molybdène 16.

Dans un autre mode de mise en oeuvre particulier du procédé objet de l'invention, on dispose une couche de résine photosensible négative sur un substrat approprié.

L'insolation de cette couche de résine photosensible négative suivant des réseaux de lignes qui sont perpendiculaires l'un à l'autre, de la manière expliquée plus haut, puis le développement de la couche de résine photosensible négative ainsi insolée conduisent à une matrice de plots de résine photosensible négative sur le substrat, les plots étant placés aux intersections des réseaux de lignes.

Les documents cités dans la présente description sont les suivants :
(1) FR-A-2 593 953 (voir aussi EP-A-0 234 989)
(2) US-A-4 857 161 (correspondant au document (1))
(3) FR-A-2 663 462 (voir aussi EP-A-0 461 990 et US-A-5 194 780)
(4) FR-A-2 687 839 (voir aussi EP-A-0 558 393 et la demande de brevet américain du 26 février 1993, numéro de série 08/022,935 de Leroux et al.)
(5) "Large scale field emitter array patterning for flat panel displays using laser interference lilhography", J.P. SPALLAS, R.D. BOYD, J.A. BRITTEN, Conférence IVMC 1995
(6) "Arrays of gated field emitter cones having 0,32 µm tip to tip spacing", C.O. BOLZER, C.T. HARRIS, S. RABE, D. RATHMAN, J.Vac. Sci. Technol. B12(2), Mars/Avril 1994, p.629
(7) Achromatic interferometric lithographed for 100 nm period gratings and grids", T.A. SAVAS, S.N. SHAH, H.I. SMITH, J.Vac. Sci. Technol. B13(6), Novembre/Décembre 1995, p.2732
(8) "Large area, free-standing gratings for atom interferometry produced using holographic lithography", J.M. CARTER, D.B. OLSTER, M.L. SCHATTENBURG, A. YEN, H.I. SMITH, J.Vac. Sci. Technol. B10 (6), Novembre/Décembre 1992, p.2909
(9) "Preshaping photoresist for refractive microlens fabrication", T.R. Jay et al., SPIE vol. 1992, Miniature and Micro-Optics and Micromechanics (1993), p. 275 à 282
(10) "One-step 3D shaping using a gray-tone mask for optical and microelectronic applications", Y. Oppliger et al., Microelectronic Engineering 23 (1994), p.449 à 454
(11) "Fabrication of relief-topographic surfaces with a one-step UV-lithographic process", H.J. Quenzer et al., p. 163 à 172
(12) "Continuous-relief microoptical elements fabricated by laser beam writing", G. Przyrembel, p. 219 à 228
(13) "Generation of relief-type surface topographies for integrated microoptical elements", J. Wengelink et al., p. 209 à 217
(14) "Laser beam lithographed micro-Fresnel lenses", M. Haruna et al., Applied Optics, vol. 29, n°34, 1 décembre 1990, p. 5120 à 5126
(15) "Lighographie tridimensionnelle par exposition à niveaux de gris", Japon Optoélectronique, n°17, Décembre 1993-Janvier-Février 1994, p. 16.

## Revendications

1. Procédé de formation de motifs dans une couche (22) de résine photosensible, ce procédé étant caractérisé en ce qu'il comprend les étapes suivantes :
- on forme des faisceaux lumineux élémentaires dont les axes sont parallèles,
- on effectue au moins une première translation relative, à vitesse et puissance lumineuse constantes, de ces faisceaux élémentaires par rapport à la couche de résine photosensible, les faisceaux élémentaires étant focalisés sur celle-ci, de manière à insoler des premières lignes parallèles (44) de cette couche, ladite vitesse et ladite puissance étant choisies de façon que chaque première ligne insolée reçoive une première dose de lumière inférieure à la dose de lumière nécessaire au développement de cette résine photosensible,
- on effectue une rotation relative, d'un angle déterminé, de l'ensemble des faisceaux lumineux élémentaires par rapport à la couche de résine photosensible (22),
- on effectue au moins une deuxième translation relative, à vitesse et puissance lumineuse constantes, de ces faisceaux élémentaires par rapport à la couche de résine photosensible, les faisceaux élémentaires étant focalisées sur celle-ci, de manière à insoler des deuxièmes lignes parallèles (48) de cette couche, ladite vitesse et ladite puissance lumineuse étant choisies de façon que chaque deuxième ligne insolée reçoive une deuxième dose de lumière égale à la différence entre ladite dose de lumière nécessaire au développement et la première dose, de sorte que seules les intersections des premières et des deuxièmes lignes reçoivent cette dose nécessaire au développement, et
- on développe la résine photosensible, des motifs étant ainsi formés en ces intersections.

2. Procédé selon la revendication 1, caractérisé en ce que les première et deuxième translations relatives sont effectuées à la même vitesse et à la même puissance lumineuse, cette vitesse et cette puissance lumineuse étant choisies de façon que les première et deuxième doses de lumière soient toutes deux égales à la moitié de la dose nécessaire au développement.

3. Procédé selon l'une quelconque des revendications 1 et 2, caractérisé en ce que l'angle de la rotation relative est égal à 90°.

4. Procédé selon l'une quelconque des revendications 1 à 3, caractérisé en ce que la couche de résine photosensible (22) reste fixe et l'ensemble de faisceaux lumineux élémentaires est déplacé par rapport à cette couche lors des première et deuxième translations.

5. procédé selon l'une quelconque des revendications 1 à 3, caractérisé en ce que l'ensemble de faisceaux lumineux élémentaires reste fixe et la couche de résine photosensible (22) est déplacée par rapport à cet ensemble lors des première et deuxième translations.

6. Procédé selon l'une quelconque des revendications 1 à 3, caractérisé en ce que l'ensemble de faisceaux lumineux élémentaires et la couche de résine photosensible (22) sont déplacés en sens contraire lors des première et deuxième translations.

7. Procédé selon l'une quelconque des revendications 1 à 6, caractérisé en ce qu'on effectue au moins une série de plusieurs premières translations successives et également au moins une série de plusieurs deuxièmes translations successives et en ce qu'on effectue, entre deux premières translations successives et entre deux deuxièmes translations successives, une translation relative de l'ensemble de faisceaux lumineux élémentaires par rapport à la couche de résine photosensible (22), perpendiculairement aux lignes correspondantes et avec un pas (LT) tel que la distance (LM) entre deux faisceaux lumineux adjacents soit un multiple de ce pas.

8. Procédé selon la revendication 7, caractérisé en ce qu'on effectue une pluralité de séries de premières et deuxièmes translations et en ce qu'on effectue, entre deux séries successives, une translation relative de l'ensemble de faisceaux lumineux élémentaires par rapport à la couche de résine photosensible (22), perpendiculairement aux lignes correspondantes et avec un pas égal à la somme de la distance (LR) entre les axes des faisceaux lumineux élémentaires les plus éloignés l'un de l'autre et de la distance (LT) entre deux lignes correspondantes adjacentes.

9. Procédé selon l'une quelconque des revendications 1 à 8, caractérisé en ce que la résine photosensible est positive de sorte que les motifs formés sont des trous.

10. Procédé selon l'une quelconque des revendications 1 à 8, caractérisé en ce que la résine photosensible est négative de sorte que les motifs formés sont des plots.

11. Dispositif de formation de motifs dans une couche de résine photosensible, pour la mise en oeuvre du procédé selon l'une quelconque des revendications 1 à 10, ce dispositif étant caractérisé en ce que qu'il comprend :
- une source lumineuse (24) apte à émettre un faisceau lumineux dont la puissance est constante,
- des moyens (30) de formation desdits faisceaux lumineux élémentaires focalisés (41), à partir du faisceau lumineux de puissance constante, et
- des moyens (38, 40, 42) de translation et de rotation relatives des moyens de formation desdits faisceaux lumineux élémentaires par rapport à la couche de résine photosensible (22), ces moyens de translation et de rotation relatives étant prévus pour effectuer lesdites première et deuxième translations relatives et ladite rotation relative.

12. Dispositif selon la revendication 11, caractérisé en ce que les moyens (30) de formation desdits faisceaux lumineux élémentaires focalisés comprennent :
- un ensemble (26) de fibres optiques (28), ces fibres optiques ayant des premières extrémités (36), dont les axes sont parallèles les uns aux autres, et des deuxièmes extrémités qui sont optiquement couplées à la source lumineuse, de manière à former les faisceaux lumineux élémentaires respectivement dans les fibres optiques, et
- un ensemble de moyens optiques de focalisation (34) qui sont optiquement couplés respectivement aux premières extrémités des fibres optiques et aptes à focaliser les faisceaux lumineux élémentaires sur la couche de résine photosensible (22).

13. Procédé de fabrication d'une source d'électrons à cathodes émissives à micropointes, procédé selon lequel :
- on forme une structure comprenant des conducteurs cathodiques (6) sur un substrat (2), une couche électriquement isolante (10) sur ces conducteurs cathodiques, et, sur cette couche électriquement isolante, des grilles (8) qui font un angle avec les conducteurs cathodiques,
- dans les domaines où les grilles croisent les conducteurs cathodiques, on forme des trous (14) à travers les grilles et la couche isolante, et
- on forme des micropointes (18) en matériau émetteur d'électrons dans ces trous, sur les conducteurs cathodiques,
ce procédé étant caractérisé en ce que ces trous sont obtenus en formant une couche de résine photosensible positive (22) au moins dans lesdits domaines, à la surface de la structure, en formant des trous dans la couche de résine conformément au procédé selon l'une quelconque des revendications 1 à 8, et en gravant les grilles et la couche isolante à travers ces trous formés dans la couche de résine.

14. Ecran plat utilisant la source d'électrons obtenue par le procédé selon la revendication 13.
